**Europäisches Patentamt**

**(19)** **European Patent Office**

**Office européen des brevets**

**(11)** **EP 0 635 460 B1**

## (12) EUROPEAN PATENT SPECIFICATION

(45) Date of publication and mention
of the grant of the patent:
**21.10.1998 Bulletin 1998/43**

(51) Int. Cl.$^6$: **C03B 37/014**

(21) Application number: **94111295.5**

(22) Date of filing: **20.07.1994**

(54) **Gas producing apparatus and method and apparatus for manufacturing optical waveguide and optical fiber preform**

Vorrichtung zur Gaserzeugung und Verfahren und Vorrichtung zum Herstellen eines optischen Wellenleiters und einer optischen Faservorform

Dispositif pour la production de gaz et procédé et appareil pour la fabrication d'un guide d'ondes et d'une préforme pour fibres optiques

(84) Designated Contracting States:
**DE FR GB IT**

(30) Priority: **22.07.1993 JP 181500/93**
**04.07.1994 JP 152222/94**

(43) Date of publication of application:
**25.01.1995 Bulletin 1995/04**

(73) Proprietor:
**SUMITOMO ELECTRIC INDUSTRIES, LTD.**
**Osaka-shi, Osaka 541 (JP)**

(72) Inventors:
- **Saito, Masahide,**
c/o Yokohama Works of
Yokohama-shi, Kanagawa 244 (JP)
- **Kanamori, Hiroo,**
c/o Yokohama Works of
Yokohama-shi, Kanagawa 244 (JP)
- **Urano, Akira,**
c/o Yokohama Works of
Yokohama-shi, Kanagawa 244 (JP)

- **Kogo, Takashi,**
c/o Yokohama Works of
Yokohama-shi, Kanagawa 244 (JP)
- **Hirose, Chisai,**
c/o Yokohama Works of
Yokohama-shi, Kanagawa 244 (JP)

(74) Representative:
**Füchsle, Klaus, Dipl.-Ing. et al**
**Hoffmann Eitle,**
**Patent- und Rechtsanwälte,**
**Arabellastrasse 4**
**81925 München (DE)**

(56) References cited:
EP-A- 0 058 571          EP-A- 0 147 663
EP-A- 0 151 200          EP-A- 0 165 493
EP-A- 0 213 715          EP-A- 0 434 966
WO-A-91/05743            US-A- 4 230 744
US-A- 4 529 427

- PATENT ABSTRACTS OF JAPAN vol. 15 no. 202
(C-834) ,23 May 1991 & JP-A-03 054130
(FUJIKURA LTD.) 8 March 1991,

EP 0 635 460 B1

# Description

## BACKGROUND OF THE INVENTION

### Field of the Invention

The present invention relates to a gas producing apparatus for producing a glass formation gas required in a flame hydrolysis deposition (FHD) method, a vapor axial deposition (VAD) method or an outside vapor deposition (OVD) method, and a method and an apparatus for manufacturing an optical waveguide and an optical fiber preform by using the glass formation gas produced by the gas producing apparatus.

### Related Background Art

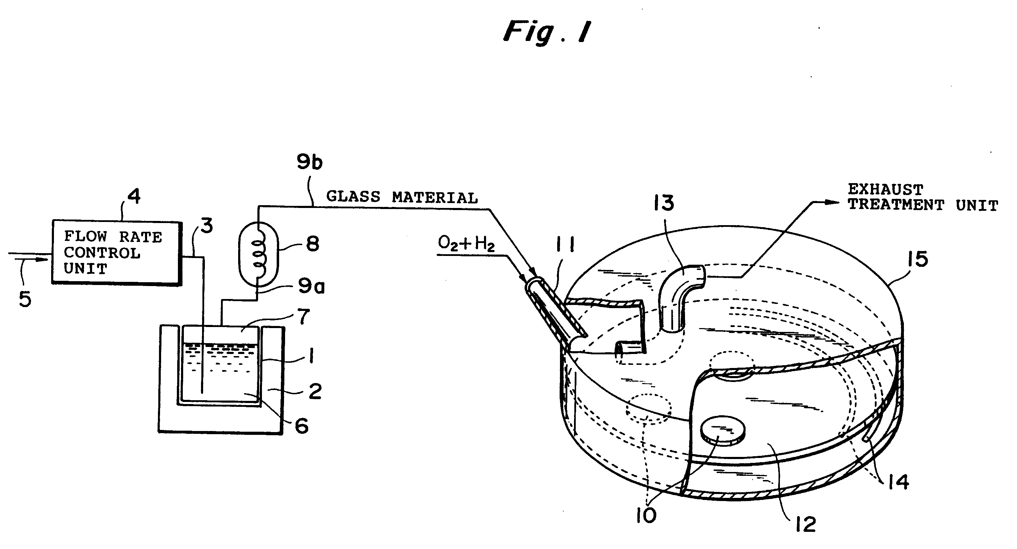

Conventionally, a glass formation gas required in the manufacture of silica-based optical waveguides is produced by, e.g., a gas producing apparatus illustrated in Fig. 1.

This gas producing apparatus produces a gas by using a carrier gas flow rate control method. Referring to Fig. 1, a liquid glass formation material is contained in a material tank 1 which is heated by a heater 2 surrounding the material tank 1. A carrier gas 5 controlled at a predetermined flow rate by a flow rate control unit 4 is supplied to the material tank 1. A material gas heated at the temperature of the heater 2 is supplied, together with the carrier gas 5, to a condenser 8 through an upper space 7 of the tank 1 and a pipe 9a. The material gas supplied to the condenser 8 is cooled to a predetermined temperature and sent as a saturated vapor gas to a burner 11 through a pipe 9b. The end of the burner 11 extends through the wall of a reactor vessel 15. The burner 11 injects the material gas supplied through the pipe 9b and a gas mixture of $O_2$ and $H_2$ supplied as a combustion gas. The material gas injected from the burner 11 is hydrolyzed by the flame of the combustion gas to yield fine glass oxide particles.

In the manufacture of optical waveguides, the fine glass oxide particles injected from the burner 11 are deposited on the surfaces of substrates 10 placed on a turntable 12 to oppose the burner 11. These substrates 10 are uniformly heated by lower heaters 14 provided below the turntable 12. Excess fine glass particles not deposited on the substrates 10 are exhausted by an exhaust pipe 13 and treated by an exhaust treatment unit provided outside the reactor vessel 15 to evacuate the reactor vessel 15 to the atmospheric pressure or lower.

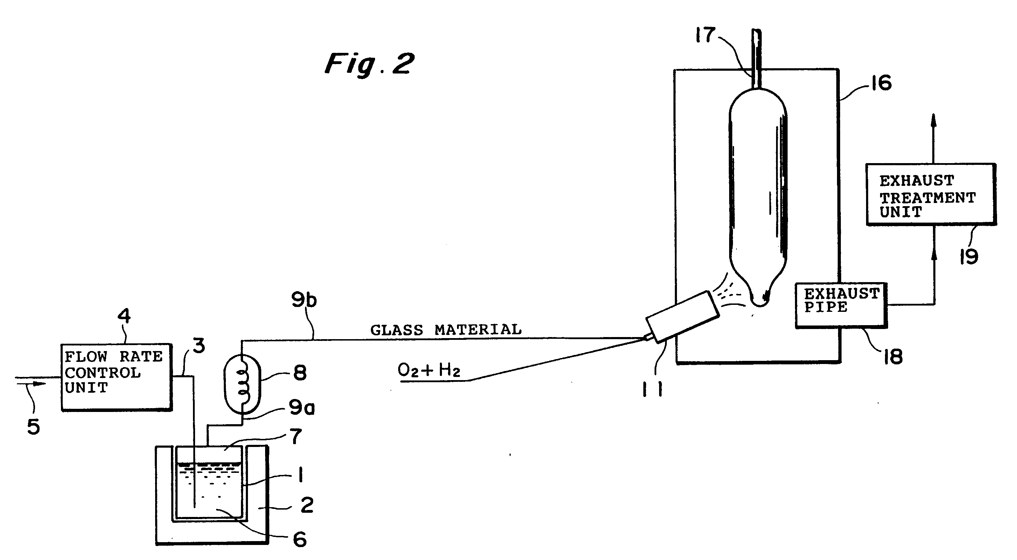

A glass formation gas required in the manufacture of optical fiber preforms is conventionally produced by, e.g., a gas producing apparatus shown in Fig. 2.

A gas production section of this gas producing apparatus has an arrangement similar to that shown in Fig. 1, so the same reference numerals as in Fig. 1 denote the same or corresponding parts in Fig. 2, and a detailed description thereof will be omitted. To manufacture an optical fiber preform, fine glass oxide particles injected from a burner 11 are deposited on a seed rod or bait 17 which is placed in a reactor vessel 16 to oppose the burner 11. Excess fine glass oxide particles not deposited on the seed rod 17 are exhausted by an exhaust pipe 18 and treated by an exhaust treatment unit 19 connected to the exhaust pipe 18.

In either of the above conventional gas producing apparatuses, however, the flow rate of the glass material gas supplied to the burner 11 varies largely due to variations in the atmospheric pressure. This introduces variations in the thickness of the layer of the fine glass oxide particles deposited on the substrate 10 or on the seed rod 17. Consequently, the thickness of a thin glass film or the diameter of an optical fiber preform obtained by vitrifying this fine-glass-particle layer cannot be uniform. That is, the thickness of the fine-glass-particle layer differs from one portion to another, resulting in a distribution in the film thickness or the preform diameter.

An apparatus according to the preamble of claim 1 and a method according to the preamble of claim 8 are known from US-A-4 230 744. This document discloses a system for delivering constituent materials of an optical waveguide blank to a deposition site.

JP-A-03 054 130 also discloses a system for feeding materials of a waveguide blank to a deposition site and includes heated pipes for delivering vapor to a glass deposition burner and a liquid flow rate control means in the form of a gear pump.

EP-A-0 213 715 discloses a method for synthesizing silica-glasses and ceramics in which heated pipes are used.

## SUMMARY OF THE INVENTION

It is an object of the present invention to provide a gas producing apparatus capable of supplying a glass material gas at a fixed flow rate without being influenced by variations in the atmospheric pressure, and a method and an apparatus for manufacturing an optical waveguide or an optical fiber preform by using the gas supplied from the gas producing apparatus.

This object is solved according to the present invention by an apparatus comprising the features of claim 1, by apparatus as defined in claims 6 and 7 and by a method comprising the features of claim 8. Detailed embodiments are described in the respective dependent claims.

According to the present invention, a gas producing apparatus for producing a glass formation gas comprises a tank for containing a liquid material which contains a glass component, a vaporizer for vaporizing the liquid material contained in the tank, liquid flow rate control means for controlling a flow rate of the liquid material supplied from the tank to the vaporizer, fixed amount supply means for maintaining a flow rate of the vaporized material output from the vaporizer constant by supplying an inert gas or a combustion gas at a fixed flow rate to the vaporizer, and a burner for producing fine glass particles by injecting the material vaporized by the vaporizer together with the combustion gas and hydrolyzing the material with flame.

A glass formation material is supplied intact in the form of a liquid to a vaporizer, and the supply quantity of this liquid material is controlled directly by a liquid flow rate control means while the material is kept in the form of a liquid. In addition, at the same time the liquid material is vaporized by the vaporizer, a fixed amount supply means supplies an inert gas or a combustion gas at a fixed flow rate to the vaporizer. Since this prevents a pressure rise in the vaporizer, the liquid material is stably supplied to the vaporizer. Therefore, a fixed amount of vaporization of the liquid material is constantly performed in the vaporizer without being influenced by variations in the atmospheric pressure. Furthermore, since the vaporised material is supplied to a burner together with the inert gas or the combustion gas supplied at a fixed flow rate from the fixed amount supply means, the burner injects a fixed amount of the material gas at any instant.

Also, a pipe for supplying the inert gas or the combustion gas from the fixed amount supply means to the vaporizer is heated to a temperature higher than the vaporization temperature of the material. Therefore, the material gas vaporized by the vaporizer is not again liquefied by the inert gas or the combustion gas, and this makes stable supply of the liquid material to the vaporizer possible. A pipe for supplying the material gas from the vaporizer to the burner is also heated to a temperature higher than the vaporization temperature of the material. Consequently, the material gas does not liquefy before it reaches the burner, so a fixed amount of the material gas can be supplied to the burner.

Moreover, a homogeneous optical waveguide or optical fiber preform can be manufactured by producing fine glass particles by injecting the material gas supplied as mentioned above against a rotating substrate or seed rod and hydrolyzing the material gas by flame.

Note that the material vaporized by the vaporizer is not necessarily a gas but in some cases in a state in which a liquid in the form of fine particles is floating in a gas. In the present invention, it is assumed that the term "gas" also includes this state.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the claims will become apparent to those skilled in the art from this detailed description.

BRIEF DESCRIPTION OF THE DRAWINGS

Fig. 1 is a block diagram showing a conventional gas producing apparatus for use in the manufacture of optical waveguides;

Fig. 2 is a block diagram showing a conventional gas producing apparatus for use in the manufacture of optical fiber preforms;

Fig. 3 is a block diagram showing a gas producing apparatus for use in the manufacture of optical waveguides according to the first embodiment of the present invention;

Fig. 4 is a sectional view showing the internal structure of a liquid flow rate controller for controlling the flow rate of a liquid material to be supplied to a vaporizer;

Fig. 5 is a sectional view showing the internal structure of an example of the vaporizer;

Fig. 6 is an enlarged sectional view showing a portion near the end of a liquid feed pipe of the vaporizer in Fig. 5;

Fig. 7 is a block diagram showing a gas producing apparatus for use in the manufacture of optical fiber preforms according to the second embodiment of the present invention;

Fig. 8 is a graph showing the transmission band characteristic distribution of optical fibers obtained from a preform manufactured by using the gas producing apparatus of the second embodiment; and

Fig. 9 is a graph showing the transmission band characteristic distribution of optical fibers obtained from a preform manufactured by a conventional gas producing apparatus.

DESCRIPTION OF THE PREFERRED EMBODIMENTS

In the conventional gas producing apparatuses illustrated in Figs. 1 and 2, a variation in a glass material gas flow rate caused by a change of the atmospheric pressure is considered as follows. That is, in a carrier gas flow rate control scheme conventionally performed in a gas producing apparatus, a flow rate $Q_S$ per unit time of a material gas supplied to a reactor vessel is represented by the following equation:

$$Q_S = Q_C \times P_S(T)/(P_0 - P_S(T)) \qquad (1)$$

where $Q_C$ is the flow rate per unit time of a carrier gas, T is the temperature of a condenser, $P_S(T)$ is the saturated vapor pressure of a material in a liquid state at the temperature T, and $P_0$ is the pressure in a pipe at the outlet of the condenser.

Since the interior of the conventional reactor vessel discussed earlier is at normal pressure, its absolute pressure varies with variations in the atmospheric pressure, and this variation results in a variation in the material gas flow rate $Q_S$. As an example, if $SiCl_4$ gas at a temperature of 36°C and a saturated vapor pressure of 360 mmHg is supplied to a condenser set at the same temperature, a variation $\Delta Q_S$ of the material gas flow rate $Q_S$ is represented by the following equation assuming that the variation of the atmospheric pressure is 760 ± 10 mmHg (about 1.3%):

$$|\Delta Q_S/Q_S| = |\Delta P_0|/(P_0 - P_S(T))$$
$$= 10/(760 - 366)$$
$$= 0.025$$

That is, a material gas flow rate variation of ±2.5% is produced for the atmospheric pressure variation of about ±1.3%. Conventionally, a flow rate variation of a material gas to this extent has been neglected. However, even a variation to this extent can no longer be neglected in order to perform more precise glass film thickness control for optical waveguides and optical fiber preforms. When optical axis alignment with an optical fiber or an optical waveguide subsequent to the manufacture of an optical waveguide or an optical fiber preform is taken into account, the film thickness distribution of a thin glass oxide film must be 30 ± 0.5 μm or less. When this is taken into consideration, therefore, it is necessary to decrease the variation $\Delta Q_S$ of the material gas flow rate $Q_S$ to ±1.7% or less, in which stability (reproducibility) of the material flow rate is sufficient.

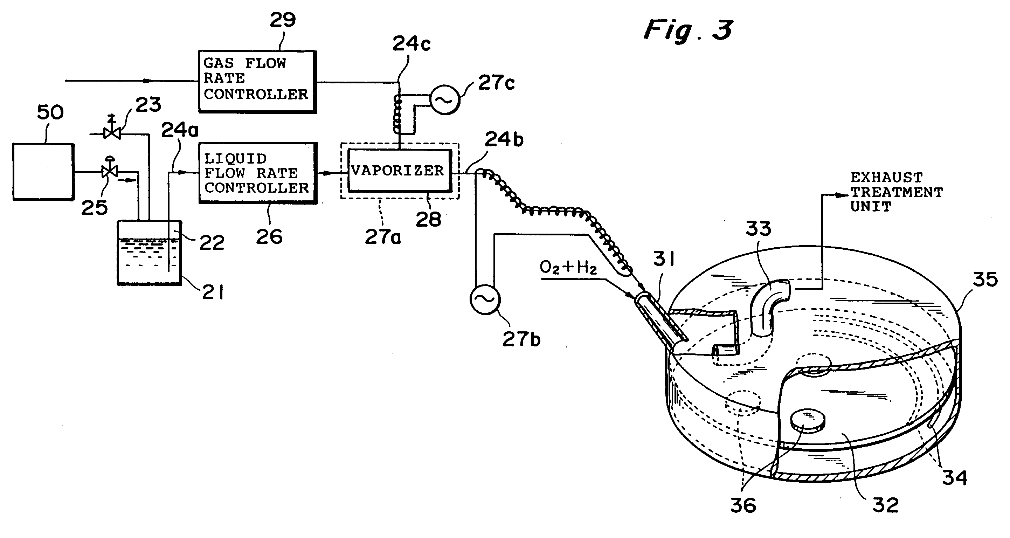

A gas producing apparatus according to the first embodiment of the present invention is described below with reference to Fig. 3. The gas producing apparatus produces a glass formation gas required in manufacturing an optical waveguide on a substrate.

A tank 21 stores a glass formation material in a liquid state. An upper space 22 of the tank 21 is pressurized by a pressure control system 23, and the liquid material stored in the tank 21 is supplied intact in the form of a liquid to a pipe 24a.

The pressure control system 23 is so designed as to supply a gas controlled in flow rate and pressure to the upper space 22 of the tank 21. At this time, the pressure of the gas is desirably at least 3.0 kgf/cm²G, in order to prevent a liquid flow from becoming unstable due to expansion of the volume of the material in a vaporizer 28, thereby allowing a stable operation of a liquid flow rate controller 26. In addition, a gas to be used must meet the conditions of not reacting with the material, not dissolving the material, and being harmless. Preferred examples of the gas are He, Ar, and $N_2$.

The material consumed in this material supply is replenished by a replenisher system. The replenishment is done by supplying the material from at least one replenisher tank 50 provided before the tank 21. It is desirable that the material be supplied from the replenisher tank 50 by He, Ar or $N_2$ at a pressure higher by 0.3 kgf/cm²G or more than the internal pressure of the tank 21. This is so because, if the pressure difference is smaller than 0.3 kgf/cm²G, the replenishing speed becomes unstable, and this makes the supply by pressure impossible depending on the positional relationship between the tank 21 and the replenisher tank 50. A replenisher flow rate controller 25 which either is identical type with the liquid flow rate controller 26 or is a needle valve or the like is arranged between the replenisher tank 50 and the tank 21. This replenisher flow rate controller 25 controls the flow rate of the material to be supplied from the replenisher tank 50 to the tank 21.

The flow rate of the liquid material supplied to the pipe 24a is controlled at a predetermined value by the liquid flow rate controller 26. The liquid material thus controlled in flow rate is sent to the vaporizer 28 surrounded by a heater 27a, and is vaporized with heat. In this case, when the material in the liquid state is vaporized to expand in the vaporizer 28, the internal pressure of the vaporizer 28 sometimes rises abruptly to become higher than the pressure of the pressure control system 23. This makes it impossible to stably supply the material in the liquid state to the vaporizer 28. Therefore, the material gas in the vaporizer 28 is exhausted outside the vaporizer 28 at a stable flow rate by producing a flow of gas with a fixed velocity by supplying a carrier gas to the vaporizer via a gas flow rate controller 29. That is, a so-called mass-flow controller is constituted. By decreasing the internal pressure of the vaporizer 28 to be lower than the pressure of the pressure control system 23 in this way, the material in the liquid state can be supplied stably. A pipe 24c for supplying the carrier gas to the vaporizer 28 is heated to a temperature higher than the vaporization temperature of the material by a heater 27c. This is so because, if the temperature of the carrier gas is lower than the temperature of the material gas, the carrier gas liquefies the material gas when joining the material gas inside the vaporizer 28, and this makes the supply of the material gas unstable. The material gas and the carrier gas are fed to a burner 31 through a pipe 24b after being mixed in the vaporizer 28. Since this pipe 24b is also heated to a temperature higher than the vaporization temperature of the material by a heater 27b, the material gas does not be liquefied before it reaches the burner 31.

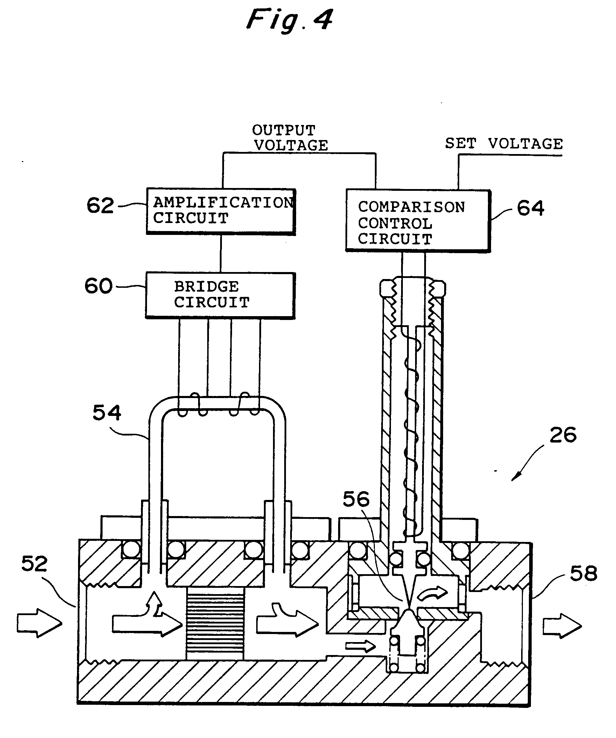

Fig. 4 is a sectional view showing an example of the liquid flow rate controller 26. The liquid flow rate controller 26 can be the type "LV-610" manufactured by the STEC incorporated. A liquid material is supplied from an inlet 52, and the flow rate of the material is sensed by a sensor unit 54. Thereafter, the liquid material is flowed to an outlet 58 through a valve unit 56. A signal indicating the flow rate sensed by the sensor unit 54 is processed by a bridge circuit 60, an amplification circuit 62, and a comparison control circuit 64. The valve opening of the valve unit 56 is controlled on the basis of the processing result, and thereby the flow rate of the material passing through the liquid flow rate controller 26 is kept at a predetermined value. The replenisher flow rate controller 25 and the gas flow rate controller 29 basically have the same structure as the liquid flow rate controller 26, and a detailed description thereof will be omitted.

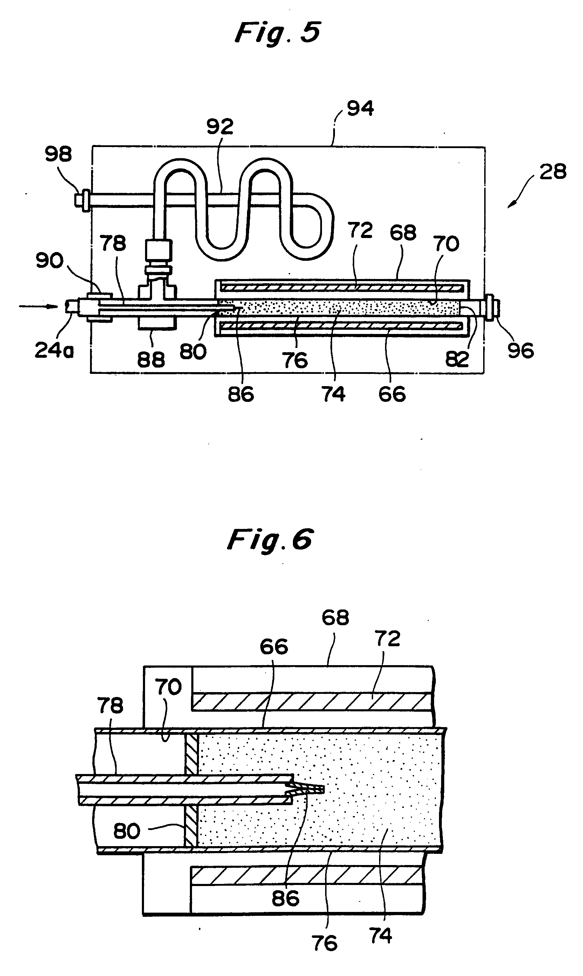

Fig. 5 is a sectional view showing an example of the vaporizer 28. Referring to Fig. 5, a pipe 66 consists of a metal with a high thermal conductivity and a high corrosion resistance, such as stainless steel. The pipe 66 is so arranged as to extend through a through hole 70 formed in a heater block 68 consisting of a metal having a high thermal conductivity, such as aluminum. A heater 72 for heating the heater block 68 and the pipe 66 is provided in the heater block 68.

A powder 74 with a high thermal conductivity and a high corrosion resistance is packed in a portion of the pipe 66 adjacent to the heater block 68. A liquid feed pipe 78 is inserted into the entrance of this portion on the upstream side. A vaporization chamber 76 is thus constituted. An example of the powder 74 is a powder consisting of a metal, such as stainless steel or titanium, or ceramics, such as SiC, and having a diameter of 100 $\mu$m or more, preferably about 120 $\mu$m. Mesh members 80 and 82 are provided at both the ends of the vaporization chamber 76 to prevent a leak of the powder 74 from the vaporization chamber 76. The mesh size is, for example, about 20 $\mu$m. The mesh member 82 on the downstream side also functions as a filter.

The liquid feed pipe 78 feeds the liquid material into the vaporization chamber 76. The liquid feed pipe 78 consists of a thin pipe having an inner diameter of 0.4 mm, like a capillary, and is arranged in a portion of the pipe 66 on the upstream side so as to be concentric with the pipe 66. The upstream end of this liquid feed pipe 78 is connected to the tank 21 via the pipe 24a. As shown in Fig. 6, the downstream end of the pipe 78 projects toward the downstream side farther than the mesh member 80, i.e., projects into the vaporization chamber 76 through the mesh member 80. A small-diameter portion 86 with an inner diameter of, e.g., 0.1 mm which is smaller than the diameter of the powder 74 is formed at the end of the liquid feed pipe 78. This small-diameter portion 86 is inserted into the portion packed with the powder 74. If the length of the powder packed portion is 150 mm, for example, the distance between the downstream end of the small-diameter portion 86 and the mesh member 80, i.e., the length of a portion of the liquid feed pipe 78 inserted into the powder 74 is appropriately 10 to 15 mm.

Referring back to Fig. 5, a block-like pipe joint 88 is provided between a connection portion 90 connecting the pipe 24a with the pipe 66 and the vaporization chamber 76. The pipe joint 88 is connected to the pipe 66. The pipe joint 88 consists of a metal with a high thermal conductivity and a high corrosion resistance, such as stainless steel. The upstream side of the pipe joint 88 is connected to a winding carrier gas feed pipe 92 which is connected to the gas flow rate controller 29. The members such as the heater block 68, the pipe joint 88, and the carrier gas feed pipe 92 are housed in a housing 94 having a heat insulating structure. The vaporized material is fed from an outlet 96 to the burner 31, and the carrier gas is fed to the carrier gas feed pipe 92 through a carrier gas inlet 98.

The vaporizer is also described in U.S.P. No. 4,529,427 or 5,078,092.

The burner 31 is supplied with a gas mixture of $O_2$ and $H_2$, as a combustion gas, in addition to the material gas, and injects the material gas and the combustion gas. The material gas thus injected causes a hydrolysis reaction due to the flame of the combustion gas. This consequently produces fine glass particles. These fine glass particles are injected against substrates 36 placed on a turntable 32 in a reactor vessel 35. Each substrate 36 is uniformly heated to 800°C by lower heaters 34 provided below the turntable 32. The turntable 32 is rotated at a velocity of 5 rpm, and the burner 31 is moved back and forth at a speed of 2.5 mm/s in the radial direction of the turntable 32. The amount of the movement of the burner 31 is 150 mm. The burner 31 supplies the fine glass oxide particles onto the surfaces of the substrates 36 placed on the turntable 32 which is rotated as described above, and this uniformly deposits a fine-glass-particle layer on the surface of each substrate 36. Excess fine glass particles not deposited on the substrates 36 are exhausted by an exhaust pipe 33 and treated by an exhaust treatment unit which is provided outside the reactor vessel 35 and evacuates the reactor vessel 35 to the atmospheric pressure or lower.

In forming an optical waveguide film, the following glass materials are first supplied from the burner 31 to the surfaces of the substrates 36, thereby depositing a fine-glass-particle buffer layer on each substrate.

| | |
|---|---|
| SiCl$_4$ | 230 cc/min |
| BCl$_3$ | 10 cc/min |
| POCl$_3$ | 2.5 cc/min |

Subsequently, the following material gases are supplied from the burner 31 to deposit a fine-glass-particle core layer on each fine-glass-particle buffer layer.

| | |
|---|---|
| SiCl$_4$ | 230 cc/min |
| GeCl$_4$ | 40 cc/min |
| POCl$_3$ | 2.5 cc/min |

After these fine-glass-particle layers are deposited, the substrates 36 are placed in an electric furnace (oven) at 1400°C. By this high-temperature heat treatment, the layers consisting of the fine glass oxide particles deposited on the surface of each substrate are sintered and vitrified. Thereafter, the vitrified core layer is patterned into ridge-like waveguides having a section of 8 μm square. An over cladding is formed on this patterned core layer, thereby manufacturing silica-based waveguides.

In the gas producing apparatus according to this embodiment, a material in a liquid state is vaporized while the flow rate of the material is controlled directly by the liquid flow rate controller 26. Consequently, the material can be stably supplied without being influenced by variations in the atmospheric pressure. In particular, since the stability (reproducibility) of the supply quantity of the liquid material of the liquid flow rate controller 26 is at least ±1.0%, it is possible to obtain a stability (reproducibility) of at least ±1.0% for the supply quantity of the material gas regardless of variations in the atmospheric pressure. Therefore, even if the internal absolute pressure of the reactor vessel varies due to variations in the atmospheric pressure, a thin glass film with a fixed film thickness can be formed at any instant. This results in a small film thickness distribution of the thin glass film.

The effectiveness of this embodiment was confirmed by the following experiment. That is, $SiCl_4$ gas was supplied at a flow rate of 230 cc/min as mentioned above to deposit a fine-glass-particle buffer layer on a metal silicon substrate 100 mm in outer diameter and 3 mm in thickness. At that time, the flow rate of liquid $SiCl_4$ was set at 1.2 cc/min by the liquid flow rate controller 26, and the flow rate of hydrogen as a carrier gas was set at 450 cc/min by the gas flow rate controller 29. In addition, the temperature of the vaporizer 28 was set at 87°C by the heater 27a, and the temperatures of the pipes 24b and 24c were set at 92°C by the heaters 27b and 27c, respectively.

Separately, in the conventional gas producing apparatus shown in Fig. 1, $SiCl_4$ gas was supplied at the same flow rate of 230 cc/min to deposit a fine-glass-particle buffer layer on a metal silicon substrate having the same dimensions. At that time, He as a carrier gas was flowed at a flow rate of 620 cc/min, the temperature of the heater 2 was set at 45°C, the temperature of the condenser 8 was set at 35°C, and the temperatures of the pipes 9a and 9b were set at 40°C.

After the buffer layers consisting of the fine glass oxide particles were deposited on the metal silicon substrates under the different conditions as described above, these substrates were heated to 1400°C to form thin glass films. Thereafter, the thin glass oxide films formed by using the gas producing apparatus of this embodiment were compared with the thin glass oxide films formed by using the conventional gas producing apparatus. Consequently, the film thickness distribution of the thin glass oxide films of silica-based waveguides formed by using the conventional gas producing apparatus was 30 ± 0.8 μm, whereas the film thickness distribution of the thin glass oxide films of silica-based waveguides formed by using the gas producing apparatus of this embodiment was 30 ± 0.3 μm. This demonstrates that the fine glass particles produced by the gas producing apparatus of this embodiment were stably supplied from the burner 31 without being influenced by variations in the atmospheric pressure, and thereby the effectiveness of this embodiment was confirmed.

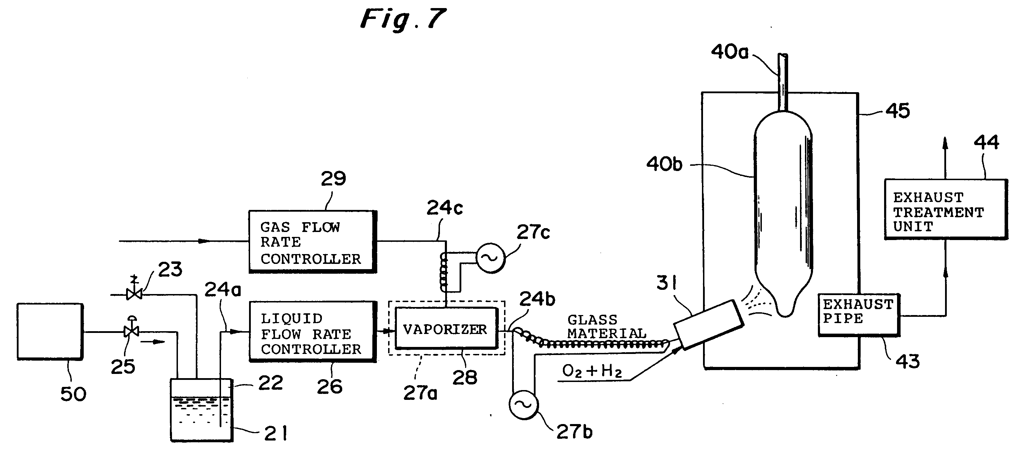

In the above embodiment, the gas producing apparatus according to the present invention is applied to the manufacture of silica-based planar optical waveguides for optical communications. However, the present invention can be applied in exactly the same fashion as discussed above to the manufacture of optical fiber preforms. Fig. 7 is a block diagram showing the second embodiment of the present invention in which the gas producing apparatus of the present invention is applied to the manufacture of optical fiber preforms. The gas producing apparatus of this second embodiment has an arrangement similar to that of the apparatus of the first embodiment discussed above. In Fig. 7, therefore, the same reference numerals as in Fig. 3 denote the same or corresponding parts, and a detailed description thereof will be omitted.

In this embodiment, fine glass oxide particles are produced following the same procedures as in the above first embodiment and injected from a burner 31. In manufacturing an optical fiber preform, the fine glass oxide particles injected from the burner 31 are blown against a seed rod 40a placed in a reactor vessel 45 at a position at which the seed rod 40a opposes the burner 31. Since the seed rod 40a is rotated, the fine glass particles are evenly deposited on its surface, and an optical fiber preform 40b grows as the deposition proceeds. Excess fine glass particles not deposited on the optical fiber preform 40b are exhausted by an exhaust pipe 43 and treated by an exhaust treatment unit 44 provided outside the reactor vessel 45 to evacuate the reactor vessel 45 to the atmospheric pressure or lower.

This second embodiment also has effects similar to those of the above first embodiment. That is, a glass formation material is supplied intact in the form of a liquid to a vaporizer 28, and the supply quantity of this liquid material is directly controlled by a liquid flow rate controller 26 while the material is kept in the form of a liquid. In addition, at the same time the liquid material is vaporized by the vaporizer 28, an inert gas is supplied to the vaporizer 28 at a fixed flow rate controlled by a gas flow rate controller 29. Since this prevents a rise in the internal pressure of the vaporizer 28, the liquid material can be stably supplied from a tank 21 to the vaporizer 28. Therefore, a fixed amount of the liquid material is vaporized by the vaporizer 28 without being affected by variations in the atmospheric pressure. Additionally, the vaporized material is supplied to the burner 31 together with the inert gas whose flow rate is fixed by the gas flow rate controller 29, so the burner 31 injects the material gas at a fixed amount at any instant. Also, since a pipe 24c for supplying the inert gas to the vaporizer 28 is heated to a temperature higher than the vaporization temperature of the material by a heater 27c, the material gas vaporized by the vaporizer 28 is not again liquefied by the inert gas. This allows stable supply of the liquid material to the vaporizer 28. Furthermore, a pipe 24b for supplying the material gas from the vaporizer 28 to the burner 31 is also heated to a temperature higher than the vaporization temperature of the material by a heater 27b, so the material gas does not liquefy before it reaches the burner 31. Therefore, a fixed amount of the material gas is constantly supplied to the burner 31. As a consequence, a fixed amount of the fine glass particles is deposited on the seed rod 40a without being affected by variations in the atmospheric pressure.

The effectiveness of this embodiment was confirmed by the following experiment. That is, optical fiber preforms were manufactured by using the gas producing apparatus according to the second embodiment and the conventional gas producing apparatus shown in Fig. 2. Thereafter, 100 graded index type optical fibers were manufactured from each optical fiber preform in accordance with a vapor-phase axial deposition method. Subsequently, the transmission band characteristic distributions of the optical fibers at a wavelength of 1.3 μm were compared.

In this case, the manufacture conditions for the optical fiber preform manufactured by using the apparatus of this embodiment were as follows. That is, to form a core, $O_2$ gas and $H_2$ gas were supplied at flow rates of 121 cc/min and 51 cc/min, respectively, to the burner 31, and a glass material gas was supplied to the burner 31 under the following conditions.

| SiCl$_4$ | 185 cc/min |
|---|---|
| GeCl$_4$ | 12 cc/min |

In order to supply SiCl$_4$ in the gaseous state at the above flow rate, SiCl$_4$ in the liquid state to be supplied to the vaporizer 28 and hydrogen as a carrier gas were flowed at 0.95 cc/min and 1200 cc/min, respectively, in the apparatus illustrated in Fig. 7. In addition, the temperature of the vaporizer 28 was set at 84°C, and the temperatures of the pipes 24b and 24c were set at 90°C. Also, to supply GeCl$_4$ in the gaseous state at the above flow rate to the burner 31, GeCl$_4$ in the liquid state to be supplied to the vaporizer and hydrogen as a carrier gas were flowed at 0.06 cc/min and 900 cc/min, respectively, in a gas producing apparatus (not shown) having a configuration similar to that of the gas producing apparatus shown in Fig. 7. The temperature of the vaporizer was set at 97°C, and the temperatures of the individual pipes were set at 92°C.

The manufacture conditions for the optical fiber preform manufactured by using the conventional apparatus were as follows. That is, to supply SiCl$_4$ in the gaseous state at the same flow rate of 185 cc/min as described above, argon as a carrier gas was flowed at 110 cc/min, the temperature of the heater 2 was set at 55°C, the temperature of the condenser 8 was set at 43°C, and the temperatures of the pipes 9a and 9b were set at 56°C, in the apparatus in Fig. 2. Also, to supply GeCl$_4$ in the gaseous state at the same flow rate of 12 cc/min as mentioned above to the burner 31, argon as a carrier gas was flowed at 80 cc/min, the temperature of the heater 2 was set at 42°C, the temperature of the condenser 8 was set at 30°C, and the temperatures of the pipes 9a and 9b were set at 56°C, in a gas producing apparatus (not shown) having an arrangement similar to that of the gas producing apparatus illustrated in Fig. 2.

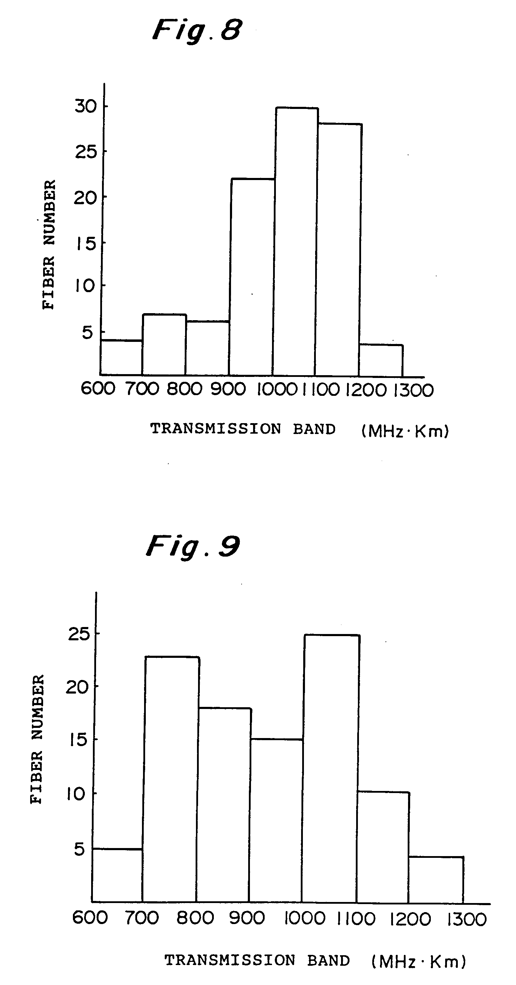

The transmission band characteristic distribution of the 100 optical fibers manufactured by using the apparatus of this embodiment was measured, and as a result the graph shown in Fig. 8 was obtained. The graph shown in Fig. 9, on the other hand, was obtained as a result of the measurement for the transmission band characteristic distribution of the 100 optical fibers manufactured by using the conventional apparatus. In each graph, the transmission band [MHz • Km] is plotted on the abscissa, and the fiber number is plotted in the ordinate. It is understood from these graphs that the transmission band characteristic distribution illustrated in Fig. 8 has a small variation compared to that shown in Fig. 9. That is, the fine-glass-particle layer deposited on the seed rod by using the gas producing apparatus of this embodiment obviously had a small film thickness distribution (preform diameter variation) and therefore was obviously formed without being influenced by variations in the atmospheric pressure.

Note that in each of the above embodiments, it is only necessary that the material gas be a gas containing one or more types of glass components, and the combustion gas be a gas containing one or more types of elements other than that of the material gas, e.g., hydrogen, oxygen, methane, and propane. In addition, the carrier gas may be either an inert gas containing one or more types of elements other than that of the material gas, e.g., helium, argon, and nitrogen, or a combustion gas. That is, an inert gas is supplied as a carrier gas to the vaporizer 28 in each of the above embodiments, but it is also possible to supply a combustion gas at a fixed flow rate to the vaporizer 28. Effects similar to those of the above embodiments also can be obtained by using these gases.

According to the present invention as has been discussed above, the glass formation material is supplied intact in the form of a liquid to the vaporizer, and the supply quantity of this liquid material is controlled by the liquid flow rate control means while the material is kept in the form of a liquid. In addition, at the same time as the liquid material is vaporized by the vaporizer, the fixed amount supply means supplies an inert gas or a combustion gas at a fixed flow rate to the vaporizer.

Since this prevents a rise in the internal pressure of the vaporizer, the liquid material can be stably supplied to the vaporizer. Therefore, a fixed amount of the liquid material is vaporized by the vaporizer without being affected by variations in the atmospheric pressure. Furthermore, the vaporized material is supplied to the burner together with the inert gas or the combustion gas which is supplied at the fixed flow rate by the fixed amount supply means. This permits the burner to inject the material gas at a fixed amount at any instant. Consequently, the film thickness distribution of the deposited fine glass particles becomes small to make formation of a glass film with good characteristics possible. Therefore, the present invention is particularly effective when applied to an apparatus for manufacturing optical parts, such as planar waveguides for optical communications, or optical fibers.

From the invention thus described, it will be obvious that the invention may be varied in many ways. Such variations are not to be regarded as a departure from the scope of the claims, and all such modifications as would be obvious to one skilled in the art are intended to be included within the scope of the following claims.

## Claims

1.  A gas producing apparatus for producing a glass formation gas, comprising:

    a tank (21) for containing a liquid material which contains a glass component;
    a vaporizer (28) for vaporizing the liquid material contained in said tank (21), said vaporizer (28) comprising a heater (27a) arranged to heat the liquid material to a predetermined heating temperature above the boiling temperature of the liquid material to vaporize the liquid material;
    liquid flow rate control means (26) for controlling a flow rate of the liquid material supplied from said tank (21) to said vaporizer (28);
    fixed amount supply means (29) for maintaining a flow rate of the vaporized material output from said vaporizer (28) constant by supplying an inert gas or a combustion gas at a fixed flow rate to said vaporizer (28);
    a burner (31) for producing fine glass particles by injecting the material vaporized by said vaporizer (28) together with the combustion gas and hydrolyzing the material with flame; and
    a pipe (24b) for supplying the vaporized material from said vaporizer (28) to said burner (31) and a pipe (24c) for supplying the inert gas or the combustion gas from said fixed amount supply means (29) to said vaporizer (28);
    characterized in that
    the pipe (24b) for supplying the vaporized material is provided with means (27b) to heat the vaporized material to a temperature above said predetermined heating temperature and the pipe (24c) for supplying the inert gas or the combustion gas is provided with means (27c) to heat the inert gas or combustion gas to a temperature above said predetermined heating temperature.

2.  A gas producing apparatus according to claim 1, further comprising pressure control means (23) for supplying by pressure the material contained in said tank (21) to said liquid flow rate control means (26) by supplying a gas controlled in flow rate and pressure to said tank (21).

3.  A gas producing apparatus according to claim 1 or 2, further comprising at least one replenisher tank (50) connected to said tank (21) to replenish the material to said tank (21).

4.  A gas producing apparatus according to claim 3, further comprising means for supplying the material contained in said replenisher tank (50) by pressure by a gas containing at least one member selected from the group consisting of helium, argon, and nitrogen.

5.  A gas producing apparatus according to claim 4, further comprising means for setting a supply pressure from said replenisher tank (50) to said tank (21) to be higher by at least 0.3 Kgf/cm$^2$G than an internal operating pressure in said tank (21), and further comprising flow rate control means (25) for controlling a flow rate from said replenisher tank (50) to said tank (21).

6.  An apparatus for manufacturing an optical waveguide by vaporizing a liquid material containing a glass component, and injecting the vaporized material from a burner (31) to deposit the material on a substrate (36), comprising an apparatus according to one of the claims 1 to 5 and a turntable (32), arranged to oppose said burner (31), for supporting and rotating a substrate (36) on which the fine glass particles thus produced deposit to form an optical waveguide.

7.  An apparatus for manufacturing an optical fiber preform (40b) by vaporizing a liquid material containing a glass component, and injecting the vaporized material from a burner (31) to deposit the material on a seed rod (40a), comprising an apparatus according to one of the claims 1 to 5 and seed rod support means, arranged to oppose said burner (31), for supporting and rotating a seed rod (40a) on which the fine glass particles thus produced deposit to form an optical fiber preform (40b).

8. A method of manufacturing an optical article by vaporizing a liquid material contained in a tank (21) and containing a glass component by a vaporizer (28), and injecting the vaporized material from a burner (31) to deposit the material on a substrate, comprising the steps of:

controlling a flow rate of the liquid material supplied to said vaporizer (28) at a predetermined value;

heating the liquid material at a predetermined heating temperature over a boiling temperature of the liquid material in said vaporizer (28) to vaporize the liquid material;

maintaining a flow rate of the vaporized material output from said vaporizer (28) to said burner (31) constant by supplying an inert gas or a combustion gas at a fixed flow rate to said vaporizer (28);

producing fine glass particles by injecting the vaporized material together with the combustion gas from said burner (31) and hydrolyzing the vaporized material with flame; and

depositing the fine glass particles thus produced on a rotating substrate;

characterized by

maintaining temperature in a pipe (24c) through which the inert gas or the combustion gas is fed to the vaporizer (28) and in a pipe (24b) which communicates between the vaporizer (28) and the burner (31) to be over the predetermined heating temperature.

9. A method according to claim 8, wherein the combustion gas contains at least one member selected from the group consisting of hydrogen, oxygen, methane, and propane.

10. A method according to claim 8, wherein the inert gas contains at least one member selected from the group consisting of helium, argon, and nitrogen.

11. A method according to one of the claims 8 to 10, characterized by supplying by pressure the material contained in said tank (21) to a liquid flow rate control means (26) by supplying a gas controlled in flow rate and pressure to said tank (21).

12. A method according to claim 11, wherein the gas for supplying the material by pressure contains at least one member selected from the group consisting of helium, argon, and nitrogen.

**Patentansprüche**

1. Gaserzeugungsvorrichtung zum Erzeugen eines Glasbildungsgases, umfassend:

einen Tank (21) zum Beinhalten eines flüssigen Werkstoffs, der eine Glaskomponente enthält;

einen Verdampfer (28) zum Verdampfen des in dem Tank (21) enthaltenen flüssigen Werkstoffs, wobei der Verdampfer (28) eine Heizung (27a) umfaßt, die ausgestaltet ist, um den flüssigen Werkstoff auf eine vorbestimmte Heiztemperatur oberhalb der Siedetemperatur des flüssigen Werkstoffs zu erhitzen, um den flüssigen Werkstoff zu verdampfen;

eine Flüssigkeitsströmungsgeschwindigkeits-Steuerungseinrichtung (26) zum Steuern einer Strömungsgeschwindigkeit des flüssigen Werkstoffs, der dem Verdampfer (21) von dem Tank (28) zugeführt wird;

eine Festwertzuführeinrichtung (29) zum Erhalten einer Strömungsgeschwindigkeit des verdampften Werkstoffaustoßes aus dem Verdampfer (28) auf einem konstanten Wert, indem dem Verdampfer (28) ein inertes Gas oder ein Verbrennungsgas unter fester Strömungsgeschwindigkeit zugeführt wird;

ein Brenner (31) zum Erzeugen feiner Glaspartikel durch Einspritzen des durch den Verdampfer (28) verdampften Werkstoffs zusammen mit dem Verbrennungsgas und Hydolysieren des Werkstoffs mit einer Flamme; und

eine Leitung (24b) zum Zuführen des verdampften Werkstoffs von dem Verdampfer (28) zum Brenner (31), und eine Leitung (24c) zum Zuführen des inerten Gases oder des Verbrennungsgases von der Festwertversorgungseinrichtung (29) zum Verdampfer (28);

**dadurch gekennzeichnet, daß**

die Leitung (24b) zum Zuführen des verdampften Werkstoffes mit einer Einrichtung (27b) zum Erhitzen des verdampften Werkstoffes auf eine Temperatur oberhalb der vorbestimmten Heiztemperatur versehen ist, und die Leitung (24c) zum Zuführen des inerten Gases oder des Verbrennungsgases mit einer Einrichtung (27c) zum Erhitzen des inerten Gases oder Verbrennungsgases auf eine Temperatur oberhalb der vorbestimmten Heiztemperatur versehen ist.

2. Gaserzeugungsvorrichtung nach Anspruch 1, weiterhin umfassend eine Drucksteuerungseinrichtung (23) zum Zuführen des in dem Tank (21) enthaltenen Werkstoffs zu der Flüssigkeitsströmungsgeschwindigkeit-Steuerungseinrichtung (26) durch Druck, indem dem Tank (21) ein bezüglich Strömungsgeschwindigkeit und Druck gesteuertes Gas zugeführt wird.

3. Gaserzeugungsvorrichtung nach Anspruch 1 oder 2, weiterhin umfassend zumindest einen Nachfülltank (50), der mit dem Tank (21) verbunden ist, um den Tank (21) mit Werkstoff nachzufüllen.

4. Gaserzeugungsvorrichtung nach Anspruch 3, weiterhin umfassend eine Einrichtung zum Zuführen des in dem Nachfülltank (50) enthaltenen Werkstoffes durch Druck, mittels eines Gases, das zumindest ein Element enthält, das aus der Gruppe ausgewählt ist, die aus Helium, Argon und Stickstoff besteht.

5. Gaserzeugungsvorrichtung nach Anspruch 4, weiterhin umfassend eine Einrichtung zum Einstellen eines Versorgungsdrucks von dem Nachfülltank (50) zum Tank (21), so daß er um zumindest 0,3 Kgf/cm$^2$G höher ist, als ein innerer Betriebsdruck in dem Tank (21), und weiterhin umfassend eine Strömungsgeschwindigkeits-Steuerungseinrichtung (25) zum Steuern einer Strömungsgeschwindigkeit von dem Nachfülltank (50) zum Tank (21).

6. Vorrichtung zum Herstellen eines Lichtwellenleiters durch Verdampfen eines eine Glaskomponente enthaltenden flüssigen Werkstoffs und Einspritzen des verdampften Werkstoffs von einem Brenner (31), um den Werkstoff auf einem Substrat (36) abzulegen, umfassend eine Vorrichtung gemäß einem der Ansprüche 1 bis 5 und einen Drehtisch (32), der angeordnet ist, um dem Brenner (31) gegenüberzuliegen, zum Tragen und Drehen eines Substrats (36), auf dem sich die derart erzeugten feinen Glaspartikel ablegen, um einen Lichtwellenleiter zu bilden.

7. Vorrichtung zum Herstellen einer Lichtleitervorform (40b) durch Verdampfen eines eine Glaskomponente enthaltenden flüssigen Werkstoffs und Einspritzen des verdampften Werkstoffs von einem Brenner (31), um den Werkstoff auf einem Impfstab (40a) abzulegen, umfassend eine Vorrichtung gemäß einem der Ansprüche 1 bis 5 und eine Impfstabtrageeinrichtung, die angeordnet ist, um dem Brenner (31) gegenüberzuliegen, zum Tragen und Drehen eines Impfstabs (40a), auf dem sich die derart erzeugten feinen Glaspartikel ablegen, um eine Lichtleitervorform (40b) zu bilden.

8. Verfahren zum Herstellen eines optischen Gegenstandes durch Verdampfen eines in einem Tank (21) enthaltenen und eine Glaskomponente enthaltenden flüssigen Werkstoffs durch einen Verdampfer (28) und Einspritzen des verdampften Werkstoffs von einem Brenner (31), um den Werkstoff auf einem Substrat abzulegen, umfassend folgende Schritte:

Steuern einer Strömungsgeschwindigkeit des dem Verdampfer (28) zugeführten flüssigen Werkstoffs auf einen vorbestimmten Wert;
Erhitzen des flüssigen Werkstoffs auf eine vorbestimmte Heiztemperatur oberhalb einer Siedetemperatur des flüssigen Werkstoffs in dem Verdampfer (28), um den flüssigen Werkstoff zu verdampfen;
Erhalten einer Strömungsgeschwindigkeit des verdampften Werkstoffausstoßes von dem Verdampfer (28) zu dem Brenner (31) einem konstanten Wert, indem dem Verdampfer (28) ein inertes Gas oder ein Verbrennungsgas unter fester Strömungsgeschwindigkeit zugeführt wird;
Herstellen feiner Glaspartikel durch Einspritzen des verdampften Werkstoffes zusammen mit dem Verbrennungsgas von dem Brenner (31) und Hydrolysieren des verdampften Werkstoffes mit einer Flamme; und
Ablegen der derart erzeugten feinen Glaspartikel auf einem sich drehenden Substrat;
**gekennzeichnet, durch**
Aufrechterhalten der Temperatur in einer Leitung (24c), durch die das inerte Gas oder das Verbrennungsgas dem Verdampfer (28) zugeführt wird, und in einer Leitung (24b), die zwischen dem Verdampfer (28) und dem Brenner (31) kommuniziert, so daß sie oberhalb der vorbestimmten Heiztemperatur liegt.

9. Verfahren nach Anspruch 8, **dadurch gekennzeichnet, daß**

das Verbrennungsgas zumindest ein Element enthält, das aus der Gruppe ausgewählt ist, die aus Wasserstoff, Sauerstoff, Methan und Propan besteht.

10. Verfahren nach Anspruch 8, **dadurch gekennzeichnet, daß**

das inerte Gas zumindest ein Element enthält, das aus der Gruppe ausgewählt ist, die aus Helium, Argon und Stickstoff besteht.

11. Verfahren nach einem der Ansprüche 8 bis 10, **gekennzeichnet, durch**

Zuführen des in dem Tank (21) enthaltenen Werkstoffs durch Druck zu einer Flüssigkeitsströmungsgeschwindigkeits-Steuerungseinrichtung (26), durch Zuführen eines bezüglich Strömungsgeschwindigkeit und Druck gesteuerten Gases zu dem Tank (21).

12. Verfahren nach Anspruch 11, **dadurch gekennzeichnet, daß**

das Gas zum Zuführen des Werkstoffs durch Druck zumindest ein Element enthält, das aus der Gruppe ausgewählt ist, die aus Helium, Argon und Stickstoff besteht.

## Revendications

1. Appareil de production d'un gaz, pour produire un gaz de formage de verre, comprenant :

   un réservoir (21) destiné à contenir un matériau liquide qui contient un composant vitreux; un vaporisateur (28) pour vaporiser le matériau liquide contenu dans ledit réservoir (21), ledit vaporisateur (28) comprenant un élément chauffant (27a) agencé pour chauffer le matériau liquide jusqu'à une température de chauffage prédéterminée au-dessus de la température d'ébullition du matériau liquide, pour vaporiser le matériau liquide ; un moyen (26) de commande du débit du liquide, pour commander un débit du matériau liquide fourni à partir dudit réservoir (21) audit vaporisateur (28) : un moyen (29) de fourniture d'une quantité fixée, pour maintenir constant un débit de fourniture du matériau vaporisé provenant dudit vaporisateur (28), en fournissant un gaz inerte ou un gaz de combustion à un débit fixé audit vaporisateur (28); un brûleur (31) pour produire de fines particules de verre en injectant le matériau vaporisé par ledit vaporisateur (28) en même temps que le gaz de combustion et en hydrolysant le matériau à l'aide d'une flamme; et un conduit (24b) pour fournir le matériau vaporisé provenant dudit vaporisateur (28) audit brûleur (31), et un conduit (24c) pour fournir audit vaporisateur (28) le gaz inerte ou le gaz de combustion provenant dudit moyen (29) de fourniture d'une quantité fixée ; caractérisé en ce que le conduit (24b) pour fournir le matériau vaporisé est pourvu de moyens (27b) pour chauffer le matériau vaporisé jusqu'à une température supérieure à ladite température de chauffage prédéterminée et le conduit (24c) pour fournir le gaz inerte ou le gaz de combustion est pourvu de moyens (27c) pour chauffer le gaz inerte ou le gaz de combustion à une température supérieure à ladite température de chauffage prédéterminée.

2. Appareil de production de gaz selon la revendication 1, comprenant de plus un moyen (23) de commande de la pression, pour fournir sous pression le matériau contenu dans ledit réservoir (21) audit moyen (26) de commande du débit de liquide en fournissant audit réservoir (21) un gaz commandé en débit et en pression.

3. Appareil de production de gaz selon la revendication 1 ou 2, comprenant de plus au moins un réservoir de réapprovisionnement (50) relié audit réservoir (21) pour réapprovisionner ledit réservoir (21) en matériau.

4. Appareil de production de gaz selon la revendication 3, comprenant de plus des moyens pour fournir le matériau contenu dans ledit réservoir de réapprovisionnement (50) sous la pression d'un gaz contenant au moins un composant choisit dans le groupe formé de l'hélium, de l'argon et de l'azote.

5. Appareil de production de gaz selon la revendication 4, comprenant de plus des moyens pour fixer une pression d'alimentation dudit réservoir de réapprovisionnement (50) audit réservoir (21) à une valeur supérieure d'au moins 0,3 Kgf/cm$^2$G à une pression de travail interne dans ledit réservoir (21), et comprenant de plus un moyen (25) de commande du débit pour commander un débit entre le réservoir de réapprovisionnement (50) et ledit réservoir (21).

6. Appareil de fabrication d'un guide d'onde optique par vaporisation d'un matériau liquide contenant un composant vitreux, et injection du matériau vaporisé à partir d'un brûleur (31) pour déposer le matériau sur un substrat (36), comprenant un appareil selon l'une des revendications 1 à 5 et un plateau rotatif (32) agencé pour être opposé audit brûleur (31), pour supporter et faire tourner un substrat (36) sur lequel les fines particules de verre ainsi produites se déposent pour former un guide d'onde optique.

7. Appareil de fabrication d'une préforme (40b) de fibre optique par vaporisation d'un matériau liquide contenant un composant vitreux, et injection du matériau vaporisé provenant d'un brûleur (31), pour déposer le matériau sur une tige d'amorce (40a), comprenant un appareil selon l'une des revendications 1 à 5 et un moyen de support de la tige d'amorce, agencée à l'opposé dudit brûleur (31), pour supporter et faire tourner une tige d'amorce (40a) sur laquelle les fines particules de verre ainsi produites se déposent pour former une préforme de fibre optique (40b).

8. Procédé de fabrication d'un article optique par vaporisation d'un matériau liquide contenu dans un réservoir (21) et contenant un composant vitreux, au moyen d'un vaporisateur (28), et injection du matériau vaporisé provenant d'un brûleur (31) pour déposer le matériau sur un substrat, comprenant les étapes consistant à :

commander un débit du matériau liquide fourni audit vaporisateur (28) à une valeur prédéterminée;

chauffer le matériau liquide à un température de chauffage prédéterminée au dessus d'une température d'ébullition du matériau liquide dans ledit vaporisateur (28) pour vaporiser le matériau liquide;

maintenir constant un débit du matériau vaporisé provenant dudit vaporisateur (28) audit brûleur (31), en fournissant un gaz inerte ou un gaz de combustion à un débit fixe audit vaporisateur (28);

produire de fines particules de verre en injectant le matériau vaporisé en même temps que le gaz de combustion provenant dudit brûleur (31) et en hydrolysant le matériau vaporisé à l'aide d'une flamme; et

déposer les fines particules de verre ainsi produites sur un substrat en rotation;

caractérisé par l'étape consistant à maintenir la température dans un conduit (24c) par lequel le gaz inerte ou le gaz de combustion est amené au vaporisateur (28), et dans un conduit (24b) qui communique entre le vaporisateur (28) et le brûleur (31) pour qu'elle soit supérieure à la température de chauffage prédéterminée.

9. Procédé selon la revendication 8, dans lequel le gaz de combustion contient au moins un composant choisi dans le groupe comprenant l'hydrogène, l'oxygène, le méthane, et le propane.

10. Procédé selon la revendication 8, dans lequel le gaz inerte contient au moins un composant choisi dans le groupe formé de l'hélium, de l'argon et de l'azote.

11. Procédé selon l'une des revendications 8 à 10, caractérisé en ce que l'on fournit sous pression le matériau contenu dans ledit réservoir (21) à un moyen (26) de commande du débit de liquide en fournissant un gaz commandé en débit et en pression audit réservoir (21).

12. Procédé selon la revendication 11, dans lequel le gaz pour fournir le matériau sous pression contient au moins un composant choisit dans le groupe formé de l'hélium, de l'argon et de l'azote.

# Fig. 1

FLOW RATE CONTROL UNIT

4

3

5

8

9b

9a

7

1

2

6

GLASS MATERIAL

$O_2+H_2$

11

13

EXHAUST TREATMENT UNIT

15

10

12

14

EP 0 635 460 B1

## Fig. 2

FLOW RATE CONTROL UNIT

GLASS MATERIAL

$O_2 + H_2$

EXHAUST TREATMENT UNIT

EXHAUST PIPE

EP 0 635 460 B1

**Fig. 3**

GAS FLOW RATE CONTROLLER — 29

24c

27c

50

23

24a

LIQUID FLOW RATE CONTROLLER — 26

VAPORIZER

24b

25

22

21

27a    28

27b

$O_2+H_2$

31

33

EXHAUST TREATMENT UNIT

35

32

34

36

EP 0 635 460 B1

# Fig.4

OUTPUT
VOLTAGE

SET VOLTAGE

62 — AMPLIFICATION
CIRCUIT

COMPARISON
CONTROL
CIRCUIT — 64

60 — BRIDGE
CIRCUIT

54

26

56

52

58

## Fig. 5

## Fig. 6

*Fig.7*

## Fig. 8

TRANSMISSION BAND  (MHz·Km)

## Fig. 9

TRANSMISSION BAND  (MHz·Km)